# EUROPÄISCHE PATENTSCHRIFT

(11) **EP 2 046 106 B1**
(45) Veröffentlichungstag und Bekanntmachung des Hinweises auf die Patenterteilung: **21.03.2012**
(21) Anmeldenummer: 07019248.9
(22) Anmeldetag: 01.10.2007
(51) Int. Cl.: H05K 9/00

(54) **Elektromagnetische Abschirmung**
Electromagnetic screening
Blindage électromagnétique

(43) Veröffentlichungstag der Anmeldung: 08.04.2009
(73) Patentinhaber: Kessel, Wolfgang, 22941 Bargteheide (DE)
(72) Erfinder: Kessel, Wolfgang, 22941 Bargteheide (DE)
(74) Vertreter: Vollmann, Heiko

(56) Entgegenhaltungen:
- EP-A- 1 725 088
- DE-A1- 4 426 454
- DE-C1- 3 922 758
- FR-A- 2 739 746
- JP-A- 9 181 478
- US-A- 5 008 486

## Beschreibung

Die Erfindung betrifft eine elektromagnetische Abschirmung für einen Raum mit den im Oberbegriff des Anspruchs 1 angegebenen Merkmalen.

Eine solche elektromagnetische Abschirmung ist beispielsweise aus EP 1 725 088 A2 bekannt. Die dort beschriebene elektromagnetische Abschirmung besteht aus überlappend angeordneten und leitend miteinander verbundenen, elektrisch leitenden Geflecht- oder Gitterabschnitten, die mit dem Erdpotential verbunden sind. Mittels der Geflecht- oder Gitterabschnitte wird um einen abzuschirmenden Raum ein homogenes Geflecht- oder Gitternetz gespannt, indem ein z. B. von einem elektromagnetischen Impuls induzierter Strom kurzgeschlossen wird.

Die Befestigung der Geflecht- oder Gitterabschnitte an einer Innenwand des abzuschirmenden Raumes kann mit Hilfe geeigneter Befestigungsmittel, beispielsweise Schraub- oder Ankerbauteilen, erfolgen, die hierbei allerdings die elektromagnetische Abschirmung durchsetzen. Da metallische, elektrisch leitende Befestigungsmittel beim Durchsetzen der Abschirmung eine unerwünschte Antennenwirkung ausüben würden, sind diese zur Befestigung der Geflecht- oder Gitterabschnitte an der Wand nicht geeignet. Daher werden in der Regel Befestigungsmittel aus einem elektrisch nicht leitenden Material, typischerweise aus Kunststoff, verwendet. Nachteilig an diesen Befestigungsmitteln ist, dass sie nur vergleichsweise geringe Lasten aufnehmen können, was dazu führen kann, dass eine verhältnismäßig große Anzahl dieser Befestigungsmittel zum Befestigen der Geflecht- oder Gitterabschnitte zu verwenden ist, was wiederum zu einem erheblichen Montageaufwand und langen Montagezeiten beim Befestigen der Geflecht- oder Gitterabschnitte führt.

Vor diesem Hintergrund liegt der Erfindung die Aufgabe zugrunde, eine elektromagnetische Abschirmung zu schaffen, die einen ausreichenden Schutz gegen einen z. B. von einer nuklearen Kettenreaktion verursachten elektromagnetischen Impuls bietet, wobei sie schnell und kostengünstig an der Wandung eines Raumes montierbar ist.

Diese Aufgabe löst die Erfindung durch eine elektromagnetische Abschirmung für einen Raum mit den in Anspruch 1 angegebenen Merkmalen sowie mit einer Hülse mit den in Anspruch 2 angegebenen Merkmalen, wobei vorteilhafte Weiterbildungen der Erfindung in den Unteransprüchen, der nachfolgenden Beschreibung sowie der Zeichnung angegeben sind.

Die erfindungsgemäße elektromagnetische Abschirmung für einen Raum weist eine den Raum umgebende elektrisch leitende, flächige Geflecht- oder Gitterstruktur auf, die an Erdpotential anliegt. Hierbei versteht die Erfindung unter einem Raum bevorzugt einen Raum eines Gebäudes oder ein Gebäude an sich. Darüber hinaus weist die Erfindung zumindest eine Hülse zur Aufnahme eines die flächige Geflecht-oder Gitterstruktur durchsetzenden Befestigungsmittels auf, die einen Teil der Abschirmung bildet.

Der Erfindung liegt somit die Idee zugrunde, Befestigungsmittel, die durch die flächige Geflecht- oder Gitterstruktur geführt sind, vollständig innerhalb der elektromagnetischen Abschirmung anzuordnen, indem die dann außerhalb der Geflecht- oder Gitterstruktur angeordneten Bereiche des bzw. der Befestigungsmittel von der bzw. den Hülsen überdeckt und somit abgeschirmt werden. Insofern erlaubt die Erfindung überdeckt und somit abgeschirmt werden. Insofern erlaubt die Erfindung in vorteilhafter Weise auch den Einsatz solcher Befestigungsmittel, die aus einem metallischen, elektrisch leitenden Material bestehen, wobei die Befestigungsmittel aufgrund des verwendeten Materials, beispielsweise Stahl, deutlich bessere Funktionseigenschaften als bislang verwendete Befestigungsmittel aufweisen können. Hierdurch ist es ggf. möglich, die Anzahl der Befestigungsmittel im Vergleich zum Stand der Technik deutlich zu verringern, wodurch der Montageaufwand und die Montagekosten beim Anbringen der elektromagnetischen Abschirmung in dem abzuschirmenden Raum erheblich gesenkt werden können.

Bei den mittels der Hülsen abgeschirmten Befestigungsmitteln kann es sich neben den zum Befestigen der Geflecht- oder Gitterstruktur an der Wand des abzuschirmenden Raumes vorgesehenen Befestigungsmitteln auch um solche Befestigungsmittel handeln, mit denen beispielsweise eine Innenverkleidung der Geflecht- oder Gitterstruktur an der Wand des Raumes befestigt wird, wobei diese Befestigungsmittel für diesen Zweck ebenfalls durch die Geflecht- oder Gitterstruktur geführt sind. Zum Befestigen der Geflecht- oder Gitterstruktur bzw. einer Innenverkleidung greifen die Befestigungsmittel zusammen mit den sie umgebenden Hülsen in an der Wand des Raumes ausgebildete Befestigungslöcher ein, in denen die Befestigungsmittel jeweils mit der sie umgebenden Hülse festgelegt werden. Dementsprechend erstreckt sich die erfindungsgemäße elektromagnetische Abschirmung im Bereich der Befestigungsstellen mit der Wand auch in diese Wand hinein.

Eine für die oben beschriebene elektromagnetische Abschirmung geeignete Hülse zur Aufnahme eines die Geflecht- oder Gitterstruktur einer elektromagnetischen Abschirmung durchsetzenden Befestigungsmittels ist aus einem elektrisch leitenden, geflecht- oder gitterförmigen Material ausgebildet.

Dementsprechend besteht die erfindungsgemäße Hülse aus einer Struktur aus metallischen, elektrisch leitenden Stäben und/oder Drähten, die derart angeordnet sind, dass sie eine engmaschige Netzstruktur bilden. Grundsätzlich können die die Netzstruktur bildenden Stäbe und vorzugsweise Drähte aus jedem elektrisch leitfähigen Material ausgebildet sein. Um eine hinsichtlich ihrer elektrischen Leitfähigkeit möglichst homogene Abschirmung zu erzielen, ist es allerdings vorteilhaft, die Hülse aus dem gleichen Material wie die flächige Geflecht- oder Gitterstruktur auszubilden, z.B. Kupfer, wobei die Hülse besonders vorteilhaft die gleiche Maschenweite sowie Stab- und/oder Drahtstärke wie die flächige Geflecht- oder Gitterstruktur der elektromagnetischen Abschirmung aufweist.

Um ein durch die flächige Geflecht- oder Gitterstruktur geführtes Befestigungsmittel in der erforderlichen Weise abschirmen zu können, ist die erfindungsgemäße Hülse zweckmäßigerweise zur vollständigen Aufnahme des außerhalb der flächigen Geflecht- oder Gitterstruktur der elektromagnetischen Abschirmung angeordneten Teils des Befestigungsmittels ausgebildet. Das heißt, dass der an der Außenseite der flächigen Geflecht- oder Gitterstruktur herausragende Teil des Befestigungsmittels zumindest umfangsseitig gänzlich von der Hülse umgeben wird.

Zur Aufnahme des außerhalb der flächigen Geflecht- oder Gitterstruktur angeordneten Bereichs des Befestigungsmittels weist die Hülse einen länglichen Grundkörper auf, der von einem im Querschnitt spiralförmig, vorzugsweise mehrlagig überlappend gewickelten Geflecht oder Gitter gebildet wird. Hierbei wird der längliche Grundkörper der Hülse von einem flachen Geflecht oder Gitter gebildet, welches aus seiner Flachebene heraus zu einem zu beiden Stirnseiten offenen Hohlkörper gewickelt ist, wobei sich die in der Wickelebene befindlichen Enden des Geflechts bzw. Gitters zumindest in einem Randbereich überlappen.

In einer besonders bevorzugten Weiterbildung der Hülse weist diese an einem Ende einen normal zu ihrer Längsausdehnung ausgerichteten, vorzugsweise umlaufenden Kragen auf. Dieser Kragen dient vorteilhaft als flächiger elektrischer Kontakt der Hülse zu der Geflecht- oder Gitterstruktur. Der Kragen ist im Bereich des offenen Endes des Grundkörpers angeordnet, das in dem an der Wand befestigten Zustand der elektromagnetischen Abschirmung der Geflecht- bzw. Gitterstruktur zugewandt ist, wobei der Kragen flächig an der Außenseite der Geflecht- bzw. Gitterstruktur anliegt. Hierdurch wird in vorteilhafter Weise eine Vielzahl elektrisch leitender Kontaktstellen zwischen der Geflecht- bzw. Gitterstruktur mit der Hülse im Bereich des Kragens gebildet.

Vorteilhaft weist ein Endbereich des Grundkörpers der Hülse zumindest zwei oder mehr etwa parallel zu einer Mittelachse des Grundkörpers ausgerichtete Einschnitte auf, wobei die zwischen den Einschnitten angeordneten Bereiche in einem Winkel von 90° zur Mittelachse des Grundkörpers nach außen gefalzt sind. Zweckmäßigerweise weisen bei dieser Ausgestaltung alle Einschnitte die gleiche Länge auf, so dass sich die nach außen gefalzten Bereiche des Grundkörpers in einer gemeinsamen Ebene quer zur Mittelachse des Grundkörpers nach außen und bei mehr als zwei Einschnitten sternförmig nach außen erstrecken.

Diese normal zur Mittelachse des Grundkörpers nach außen auskragenden Bereiche können den an der Außenseite der Geflecht- oder Gitterstruktur zur Anlage kommenden Kragen der erfindungsgemäßen Hülse bilden. Bevorzugt ist allerdings eine Ausgestaltung, bei der die Hülse zumindest zweiteilig ausgebildet ist, wobei zumindest ein flacher Geflecht- oder Gitterabschnitt den Kragen bildet und wobei der flache Geflecht- oder Gitterabschnitt eine von dem Grundkörper durchsetzte Ausnehmung aufweist und in flächigem Kontakt auf den nach außen gefalzten Bereichen des Grundkörpers der Hülse aufliegt. Bei dieser Ausbildung bildet der flache Geflecht- bzw. Gitterabschnitt vorteilhaft einen um den gesamten Umfang des Grundkörpers umlaufenden Kragen, der sicherstellt, dass die Geflecht- oder Gitterstruktur und die erfindungsgemäße Hülse durch eine flächige elektrische Kontaktierung bei der Anlage des den Kragen bildenden flachen Geflecht- oder Gitterabschnitts an der Geflecht- oder Gitterstruktur eine im Wesentlichen lückenlose elektromagnetische Abschirmung bilden. Vorteilhaft können der flache Geflecht- oder Gitterabschnitt und der Grundkörper der Hülse hierbei aus dem gleichen Material hergestellt sein.

Zweckmäßigerweise sind der den Kragen bildende flache Geflecht-oder Gitterabschnitt und die nach außen gefalzten Bereiche des Grundkörpers miteinander mechanisch verbunden. Hierbei ist bevorzugt eine Verbindung mittels metallischer Heftklammern vorgesehen. Die zur mechanischen Verbindung des flachen Geflecht- bzw. Gitterabschnitts mit den nach außen gefalzten Bereichen des Grundkörpers verwendeten Heftklammern bestehen bevorzugt aus dem gleichen Material wie die miteinander zu verbindenden Teile. Mit den Heftklammern werden der flache, den Kragen bildende Geflecht- bzw. Gitterabschnitt und die nach außen gefalzten Bereiche des Grundkörpers im Bereich ihrer Überlappung sowohl form- als auch kraftschlüssig verbunden.

Insbesondere dann, wenn die elektromagnetische Abschirmung lediglich zum Ableiten von elektromagnetischen Impulsen einer vergleichsweise geringen Intensität vorgesehen ist und/oder wenn der Innenquerschnitt der bei dieser elektromagnetischen Abschirmung verwendeten Hülsen verhältnismäßig klein ist, kann es vorteilhaft sein, das von dem Kragen beabstandete Ende der Hülse offen auszubilden. Das heißt, die von dem Ende mit den nach außen gefalzten Bereichen beabstandete Stirnseite des Grundkörpers der Hülse ist offen. Bevorzugt wird aber eine Ausbildung, bei der das von dem Kragen beabstandete Ende der Hülse, also die von dem Kragen beabstandete Stirnseite des Grundkörpers, geschlossen ausgebildet ist, wodurch eine vollständig geschlossene, elektromagnetische Abschirmung geschaffen werden kann.

Vorteilhaft weist die erfindungsgemäße Abschirmung mit überlappend angeordneten und leitend miteinander verbundenen elektrisch leitenden Geflecht- oder Gitterabschnitten, die mit dem Erdpotential elektrisch verbunden und im Überlappungsbereich gefalzt ausgebildet sind, eine Befestigungsschiene auf. Gemäß der Erfindung sind zwischen den hakenförmig ineinander greifenden Falzen Befestigungsschienen aus einem elektrisch leitenden Material, vorzugsweise Kupfer, angeordnet. Durch ihr Ineinandergreifen bilden die Falze der miteinander zu verbindenden Geflecht- oder Gitterabschnitte längliche Taschen die zur Aufnahme der Befestigungsschienen vorgesehen sind. Zweckmäßigerweise werden die Falze in diesem Zustand bevorzugt mittels Heftklammern aus Kupfer miteinander verbunden. Die Befestigungsschienen dienen zur Befestigung der Geflecht- oder Gitterabschnitte an der Wand eines Raumes. Zu diesem Zweck weisen sie zumindest eine Ausnehmung zur Aufnahme eines Befestigungsmittels, z.B. einer Gewindeankerstange auf, mittels dem sie zusammen mit den Geflecht- oder Gitterabschnitten an der Wand festgelegt werden können. Die Befestigungsschienen sind vorzugsweise horizontal angeordnet, können allerdings ggf. auch vertikal verbaut werden.

Nachfolgend ist die Erfindung anhand von in der Zeichnung dargestellten Ausführungsbeispiele näher erläutert. In der Zeichnung zeigen:
- Fig. 1: in schematischer, perspektivischer Darstellung eine Hülse zur Aufnahme eines die Geflecht- oder Gitterstruktur einer elektromagnetischen Abschirmung durchsetzenden Befestigungsmittels in einer ersten Ausführungsform,
- Fig. 2: die Hülse nach Fig. 1 in einer Draufsicht,
- Fig. 3: in Schnittdarstellung die Hülse nach Fig. 1 im Einbauzustand in einer Wand,
- Figuren 4a - 4d: Verfahrensschritte bei der Herstellung der Hülse nach Fig. 1,
- Fig. 5: in Darstellung nach Fig. 1 eine zweite Ausführungsform einer Hülse,
- Fig. 6: in Schnittdarstellung die Hülse nach Fig. 5 im Einbauzustand in einer Wand,
- Figuren 7a - 7d: Verfahrensschritte bei der Herstellung der Hülse nach Fig. 5,
- Figuren 8a - 8h: Verfahrenschritte beim Anbringen der erfindungsgemäßen elektromagnetischen Abschirmung an einer Wand eines Raumes,
- Fig. 9: eine vergrößerte Ansicht eines Schnitts entlang der Schnittlinie VIII-VIII in Fig. 8,
- Fig. 10: in einer Explosionsdarstellung die Befestigung einer einwandigen elektromagnetischen Abschirmung an einer Wand eines Raumes und
- Fig. 11: in einer Explosionsdarstellung die Befestigung einer doppelwandigen elektromagnetischen Abschirmung an einer Wand eines Raumes.

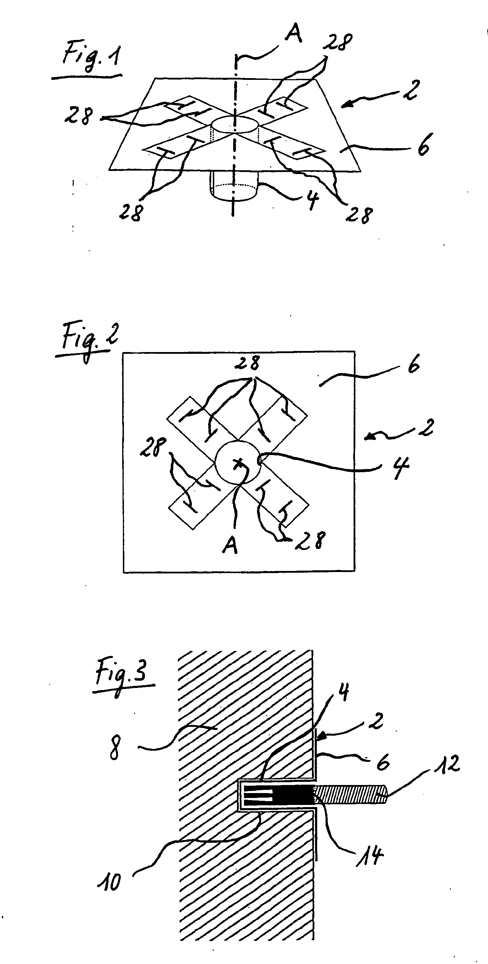

Die in den Figuren 1 bis 3 dargestellte Hülse 2 ist zweiteilig ausgebildet und weist einen hohlzylindrischen Grundkörper 4 und einen rechteckigen Kragen 6 auf, wobei sich der Kragen 6 normal zu einer Mittelachse A des Grundkörpers 4 bzw. der Hülse 2 erstreckt. Sowohl der Grundkörper 4 als auch der Kragen 6 sind aus einem Kupferdrahtgeflecht mit geringer Drahtstärke und Maschenweite ausgebildet.

Zur Befestigung einer Geflecht- bzw. Gitterstruktur einer elektromagnetischen Abschirmung an einer Wand 8 eines Raumes, wird die Hülse 2 in ein an der Wand 8 vorbereitetes Bohrloch 10 gesteckt (Fig. 3), wobei der Grundkörper 4 der Hülse 2 in das Bohrloch 10 eingreift und der Kragen 6 an der Wand 8 zur Anlage kommt. Anschließend wird ein Befestigungsmittel zum Befestigen der Geflecht- bzw. Gitterstruktur an der Wand 8 in den Grundkörper 4 der Hülse 2 eingeführt. Bei dem in Fig. 3 dargestellten Ausführungsbeispiel wird das Befestigungsmittel von einer Gewindeankerstange 12 gebildet, die in dem Befestigungsloch 10 zusammen mit der Hülse 2 mittels eines Spreizdübels 14 festgelegt ist.

An der von der Wand 8 abgewandten Seite des Kragens 6 ragt im festgelegten Zustand der Gewindeankerstange 12 ein Abschnitt dieser Gewindeankerstange 12 aus der Hülse 12 heraus. Wie im weiteren Verlauf noch näher erläutert wird, dient dieser Abschnitt zum Befestigen einer Geflecht- oder Gitterstruktur einer elektromagnetischen Abschirmung an der Wand 8, wobei dieser Abschnitt der Gewindeankerstange 12 die Geflecht- oder Gitterstruktur durchsetzt und an deren von der Wand abgewandten Seite mit weiteren geeigneten Befestigungsmitteln die Geflecht- oder Gitterstruktur an der Wand 8 festlegt.

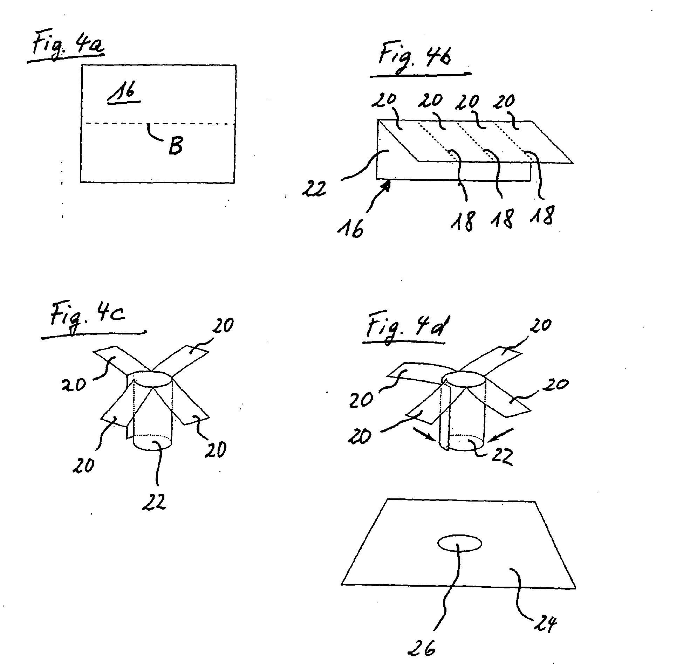

Gemäß den Fig. 4a bis 4d erfolgt die Herstellung der Hülse 2 im Wesentlichen in vier Verfahrensschritten. Ausgangspunkt bildet hierbei ein rechteckiger Drahtgeflechtabschnitt 16 mit einer Länge von etwa 50 mm und einer Breite von 40 mm, der zunächst in Längsrichtung entlang einer Mittellinie B in einem Winkel von etwa 90° gefalzt bzw. geknickt wird (Fig. 4a). Anschließend werden an dem gefalzten Bereich des Drahtgeflechtabschnitts 16 drei Einschnitte 18 vorgenommen, die normal oder leicht schräg zur Mittellinie B des Drahtgeflechtabschnitts 16 ausgerichtet sind und sich genau bis zu dieser Mittellinie B erstrecken. Die Einschnitte 18 sind derart angeordnet, dass sich hierdurch vier gleich große, in einer Richtung quer zur Mittellinie B des Drahtgeflechtabschnitts 16 voneinander getrennte Abschnitte 20 ergeben (Fig. 4b). Darauf folgend wird der in Richtung der Mittellinie B über die gesamte Länge des Drahtgeflechtabschnitts 16 zusammenhängende Bereich 22 des Drahtgeflechtabschnitts 16 zu einem Hohlzylinder mit einem Durchmesser von ungefähr 8 mm überlappend gewickelt, wobei sich die in Richtung der Mittellinie B voneinander beabstandeten Endbereiche des Bereichs 22 des Drahtgeflechtabschnitts 16 überlappen und sich die Abschnitte 20 über den Umfang des Hohlzylinders, der später den Grundkörper 4 der Hülse 2 bilden wird, verteilt auffächern (Fig.4 c). Das so entstehende Gebilde wird nachfolgend mit einem zweiten rechteckigen Drahtgeflechtabschnitt 24 von 70 x 70 mm, dem späteren Kragen 6 der Hülse 2, zusammengefügt. Der Drahtgeflechtabschnitt 24 ist aus dem gleichen Material wie der Drahtgeflechtabschnitt 16 ausgebildet und weist zentrisch eine Ausnehmung 26 auf, deren Querschnitt komplementär zur Außenquerschnittskontur des von dem Bereich 22 des Drahtgeflechtabschnitts 16 gebildeten Hohlzylinders ist (Fig. 4d). Durch die Ausnehmung 26 wird nun der von dem Bereich 22 des Drahtgeflechtabschnitts 16 gebildete Hohlzylinder hindurch gesteckt, bis die Abschnitte 20 auf dem Drahtgeflechtabschnitt 24 aufliegen. Schließlich werden die Abschnitte 20 jeweils in der aus den Figuren 1 und 2 hervorgehenden Weise mittels metallischer Heftklammern 28 miteinander verbunden: Die Hülse 2 ist dann fertiggestellt.

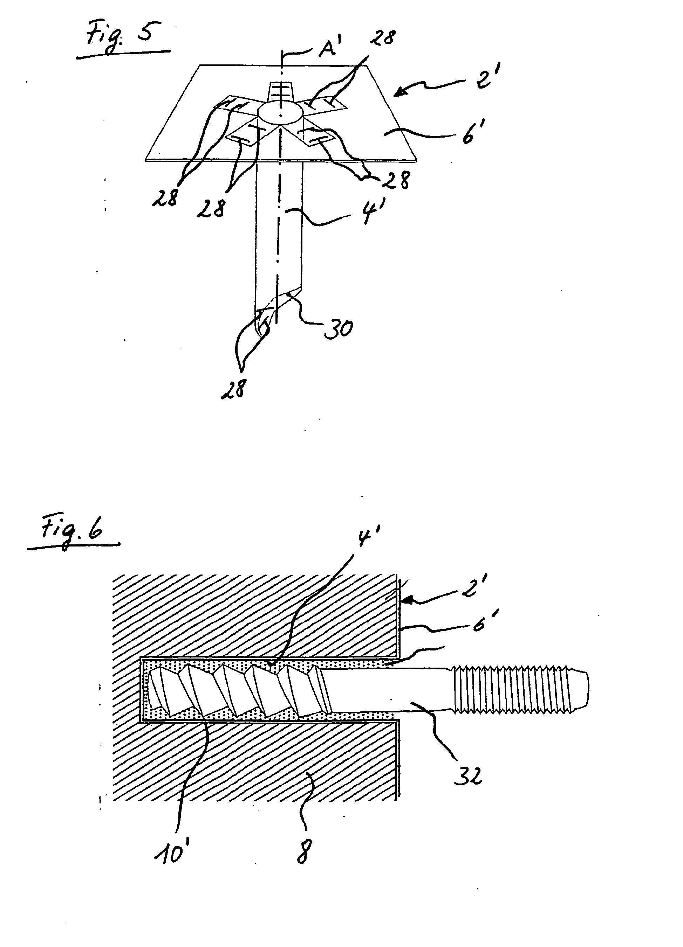

Die in den Fig. 5 und 6 dargestellte Hülse 2' ist wie die Hülse 2 zweiteilig mit einem hohlzylindrischen Grundkörper 4' und einem rechteckigen, sich normal zu einer Mittelachse A' des Grundkörpers 4' erstreckenden Kragen 6' ausgebildet. Von der in den Fig. 1 bis 3 dargestellten Hülse 2 unterscheidet sich die Hülse 2' hinsichtlich ihrer größeren Abmessungen sowie dahingehend, dass der Kragen 6' doppellagig und der Grundkörper 4' doppelwandig ausgebildet sind. Ein weiteres Unterscheidungsmerkmal der Hülse 2' ist es, dass das von dem Kragen 6' beabstandete Ende des Grundkörpers 4' bzw. der Hülse 2' geschlossen ausgebildet ist, indem das den Grundkörper 4' bildende Drahtgeflecht in einem Endbereich 30 des Grundkörpers 4' zusammengedrückt, in Richtung des Kragens 6' geknickt und in Anlage an dem sich in Richtung des Kragens 6' an den Knick anschließenden Bereich des Grundkörpers 4' mit metallischen Heftklammern 28 fixiert ist.

Wie Fig. 6 zu entnehmen ist, dient die Hülse 2' zur Aufnahme eines Injektionsankers 32, wobei die Hülse 2' mit dem darin eingreifenden Injektionsanker 32 in einem an der Wand 8 ausgebildeten Bohrloch 10' mittels Injektionsmörtel 34 festgelegt ist.

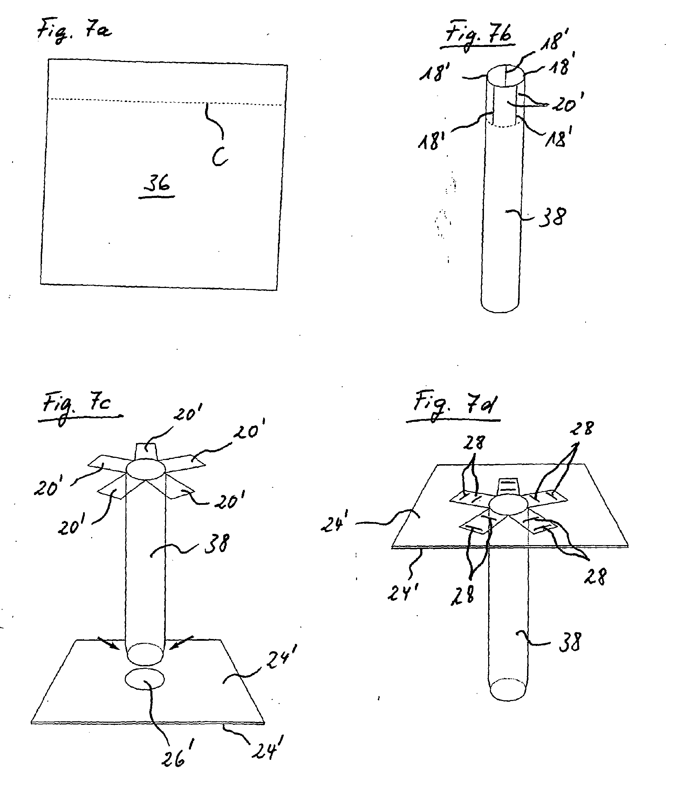

Das Verfahren zur Herstellung der Hülse 2'wird nachfolgend anhand der Fig. 7a bis 7d beschrieben. Ausgangspunkt der Hülse 2' bildet ein quadratischer Drahtgeflechtabschnitt 36 von 170 x 170 mm, der entlang einer parallel zu einer Seitenkante des Drahtgeflechtabschnitts 36 verlaufenden und von dieser 30 mm beabstandeten Linie C gefalzt wird (Fig. 7a). Anschließend wird der Drahtgeflechtabschnitt 36 in Richtung der Linie C zu einem Hohlzylinder 38 mit einem Durchmesser von 20 mm gewickelt, wobei dass dann überlappende Ende des Drahtgeflechtabschnitts 36 so groß ist, dass es spiralfömig noch ein weiteres Mal um den Umfang des entstandenen Hohlzylinders 38 gewickelt werden kann, so dass der Hohlzylinder 38 eine doppelte Wandung erhält. Daraufhin wird ein Endbereich des Hohlzylinders 38 mit fünf parallel zur Längsausdehnung des Hohlzylinders 38 ausgerichteten, 30 mm langen Einschnitten 18' versehen, die in jeweils gleichem Abstand voneinander über den Umfang des Hohlzylinders 38 verteilt sind und so den Endbereich des Hohlzylinders in fünf in Längsrichtung des Hohlzylinders 38 voneinander getrennte Bereiche 20' aufteilen (Fig. 7b). Danach werden die Bereiche 20', wie in Fig. 7c dargestellt in einem Winkel von etwa 90° nach außen gefalzt. Die weiteren Verfahrensschritte entsprechen im Wesentlichen dem bereits beschriebenen, wobei zur Bildung des Kragens zwei direkt übereinanderliegende quadratische Drahtgeflechtabschnitte 24' von 250 x 250 mm verwendet werden, die jeweils zentrisch eine mit dem Querschnitt des Hohlzylinders 38 korrespondierende Durchbrechung 26' mit einem Durchmesser von 20 mm aufweisen.

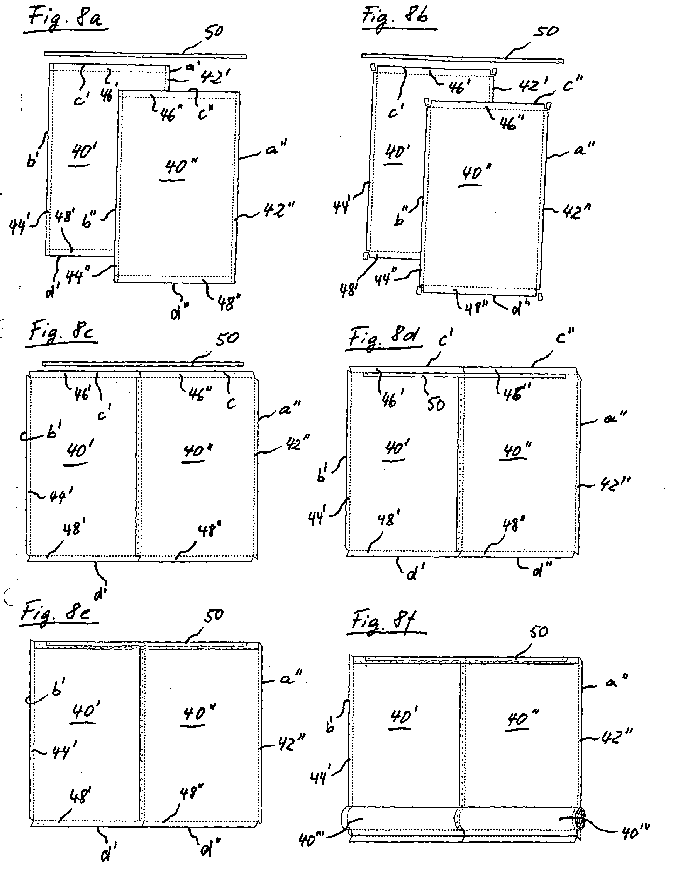

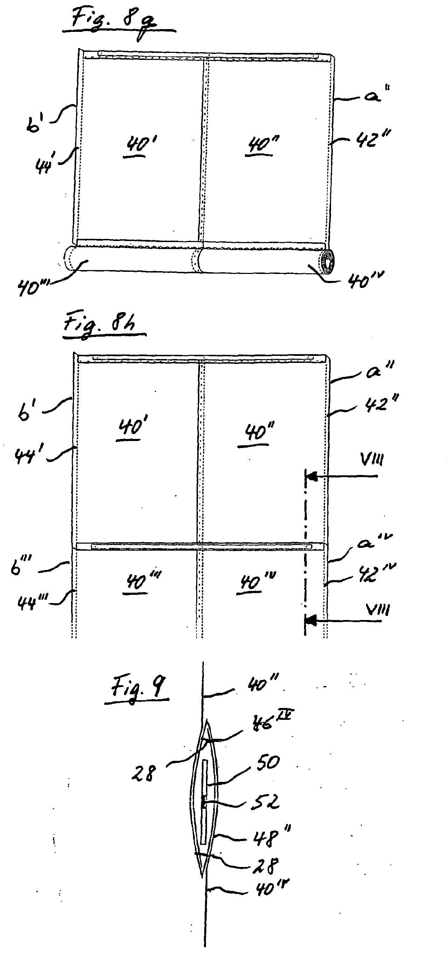

Nachfolgend wird die Befestigung einer Geflecht- oder Gitterstruktur einer elektromagnetischen Abschirmung anhand der Fig. 8a bis 8h sowie 9 bis 11 an einer Wand 8 eines abzuschirmenden Raumes beschrieben.

Die Geflecht- bzw. Gitterstruktur wird von einer Vielzahl von elektrisch leitenden Drahtgeflechtabschnitten 40 gebildet, die miteinander überlappend und leitend so verbunden sind, dass sich ein einen Raum vollständig umgebendes Geflecht bzw. Gitter ergibt. Die Drahtgeflechtabschnitte 40 weisen eine rechteckige Form auf. Zunächst werden die Drahtgeflechtabschnitte 40 an ihren Längsseiten a und b und an ihren Querseiten c und d gefalzt, wobei sich an den Längsseiten a und b die Falze 42 und 44 und an den Querseiten c und d die Falze 46 und 48 ergeben. Hierzu werden an den vier Ecken der Drahtgeflechtabschnitte entsprechend der Breite der sich dort überlappenden Falze rechteckige Stücke ausgeschnitten (Fig. 8b). Anschließend werden zwei Drahtgeflechtabschnitte 40' und 40" längsseitig miteinander verbunden, wobei die an den betreffenden Längsseiten ausgebildeten Falze kappnahtartig ineinander greifen und mittels Heftklammern aus Kupfer miteinander fixiert werden (Fig. 8c). Danach wird eine zur Befestigung an einer Wand 8 vorgesehene Kupferschiene 50, die in Längsrichtung Bohrungen 52 zur Aufnahme der Gewindeankerstange 12, aufweist, an die im Bereich der Querseite c ausgebildete Falzkante gelegt (Fig. 8d) und anschließend die Falze 46', 46" der miteinander längsseitig verbundenen Drahtgeflechtabschnitte 40', 40" über die Kupferschiene 50 umgelegt, wobei die Falze 46', 46" die Kupferschiene 50 vollständig überlappen. Danach werden die Falze 46', 46" mit den Drahtgeflechtabschnitten 40', 40" mit Heftklammern 28 so geheftet, dass eine Tasche gebildet wird, in der die Kupferschiene 50 freibeweglich angeordnet ist (Fig. 8e). In einem nächsten Verfahrensschritt werden zwei weitere längsseitig miteinander verbundene aufgerollte Drahtgeflechtabschnitte 40"' und 40^{IV} an der Querseite d der Drahtgeflechtabschnitte 40', 40" befestigt, wobei die an den betreffenden Querseiten ausgebildeten Falze kappnahtartig ineinander greifen und mittels Heftklammern 28 miteinander unter Bildung einer Tasche fixiert werden. In die so gebildete Tasche wird eine weitere Kupferschiene 50 eingeschoben (Fig. 9).

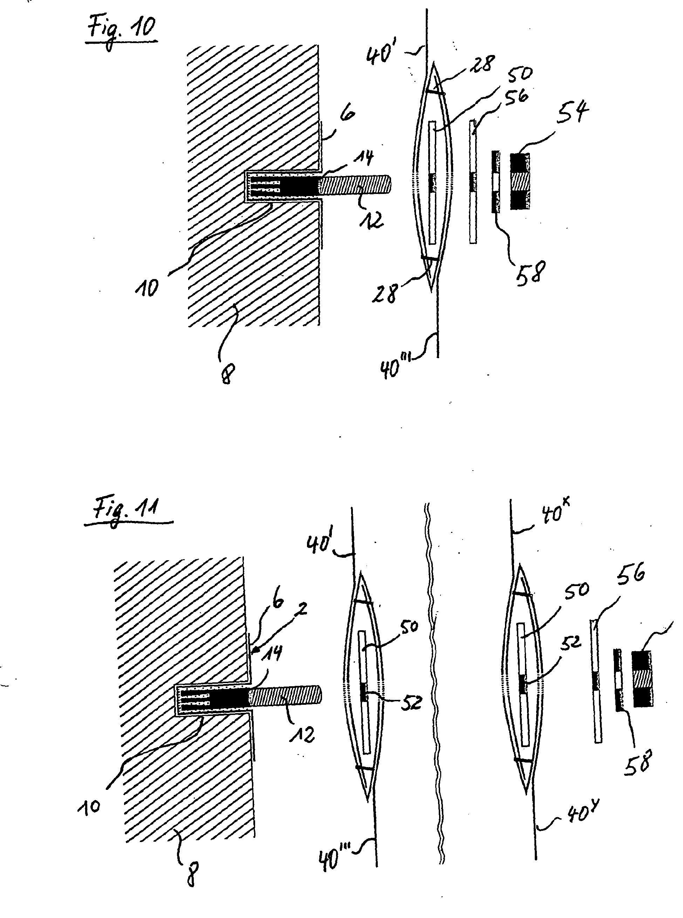

Die Befestigung der Drahtgeflechtabschnitte 40', 40" 40''' und 40^{IV} mittels der Kupferschienen 50 wird aus Fig. 10 deutlich. Wie bereits anhand von Fig. 3 beschrieben, greift eine Hülse 2 mit einer darin angeordneten Gewindeankerstange 12 in ein an der Wand 8 ausgebildetes Befestigungsloch, in dem die Hülse 2 mit der Gewindeankerstange 12 von einem Spreizdübel 14 gehalten werden. Zur Befestigung der Drahtgeflechtabschnitte 40' und 40''' wird die in der von diesen Drahtgeflechtabschnitte 40' und 40''' gebildeten Tasche angeordnete Kupferschiene 50 derart geführt, dass das aus der Hülse 2 herausragende Ende der Gewindeankerstange 12 die an der Kupferschiene 50 ausgebildete Bohrung 52 durchstößt. Anschließend wird die Kupferschiene 50 soweit in Richtung Wand bewegt, bis der außenseitig der Kupferschiene 50 angeordnete Bereich des Drahtgeflechtabschnitts 40' den Kragen 6 der Hülse 2 kontaktiert. Daraufhin werden die Drahtgeflechtabschnitte 40' und 40''' mittels einer auf die Gewindeankerstange 12 aufgeschraubten Mutter 54 befestigt, wobei zwischen den Drahtgeflechtabschnitten 40' und 40''' eine auf dem Drahtgeflechtabschnitt 40''' zur Anlage kommende Unterlegplatte 56 aus Kupfer und eine Unterlegscheibe 58 aus Edelstahl angeordnet sind. Das in Fig. 11 dargestellte Ausführungsbeispiel entspricht im Wesentlichen dem in Fig. 10 gezeigten, mit dem Unterschied, dass hier eine doppelwandige Abschirmung mit zwei übereinander angeordneten Drahtgeflechtabschnitten ausgebildet ist, wobei zwischen diesen Drahtgeflechtabschnitten eine Folie 60 angeordnet ist, die die Drahtgeflechtabschnitte voneinander räumlich trennt.

### Bezugszeichenliste

- 2, 2': Hülse
- 4, 4': Grundkörper
- 6, 6': Kragen
- 8: Wand
- 10, 10': Bohrloch
- 12: Gewindeankerstange
- 14: Spreizdübel
- 16: Drahtgeflechtabschnitt
- 18, 18': Einschnitte
- 20, 20': Abschnitte
- 22: Bereich
- 24: Drahtgefechtabschnitt
- 26, 26': Ausnehmung
- 28: Heftklammer
- 30: Endbereich
- 32: Injektionsanker
- 34: Injektionsmörtel
- 36: Drahtgeflechtabschnitt
- 38: Hohlzylinder
- 40: Drahtgeflechtabschnitt
- 42: Falz
- 44: Falz
- 46: Falz
- 48: Falz
- 50: Kupferschiene
- 52: Bohrung
- 54: Mutter
- 56: Unterlegplatte
- 58: Unterlegscheibe
- 60: Folie
- A, A': Mittelachse
- B: Mittellinie
- C: Linie
- a: Längsseite
- b: Längsseite
- c: Querseite
- d: Querseite

## Patentansprüche

1. Elektromagnetische Abschirmung für einen Raum, mit einer den Raum umgebenden, elektrisch leitenden und an Erdpotential anliegenden flächigen Geflecht- oder Gitterstruktur, **dadurch gekennzeichnet, dass** zumindest eine Hülse (2, 2') zur Aufnahme eines die flächige Geflecht- oder Gitterstruktur durchsetzenden Befestigungsmittels (12, 32) vorgesehen ist, wobei das Befestigungsmittel (12, 32) zum Befestigen der Geflecht- oder Gitterstruktur an einer Wand (8) des abzuschirmenden Raumes vorgesehen ist, und wobei die Hülse (2, 2') einen Teil der Abschirmung bildet.

2. Elektromagnetische Abschirmung, nach Anspruch 1, **dadurch gekennzeichnet, dass** sie überlappend angeordnete und leitend miteinander verbundene elektrisch leitende Geflecht- oder Gitterabschnitte (40', 40", 40"', 40^{IV}) aufweist, die mit dem Erdpotential elektrisch verbunden sind und die im Überlappungsbereich gefalzt ausgebildet sind, wobei die Falze (46, 48) benachbarter Geflecht- oder Gitterabschnitte (40) im Querschnitt hakenförmig ineinander greifen und wobei zwischen hakenförmig ineinander greifenden Falzen (46, 48) eine Befestigungsschiene (50) aus einem elektrisch leitenden Material, vorzugsweise Kupfer, angeordnet ist.

3. Hülse (2, 2'), welche einen Teil einer elektromagnetischen Abschirmung für einen Raum nach Anspruch 1 bildet und welche aus einem elektrisch leitenden, geflecht- oder gitterförmigen Material ausgebildet ist, **dadurch gekennzeichnet, dass** die Hülse (2, 2') einen länglichen Grundkörper (4, 4') aufweist, der von einem im Querschnitt spiralförmig vorzugsweise mehrlagig gewickelten Geflecht- oder Gitter gebildet wird.

4. Hülse (2, 2') nach Anspruch 3, **dadurch gekennzeichnet, dass** die Hülse (2, 2') derart ausgebildet ist, dass in ihr ein außerhalb einerflächigen Geflecht- oder Gitterstruktur der elektromagnetischen Abschirmung angeordneter Bereich eines die Geflecht- oder Gitterstruktur durchgreifenden Befestigungsmittels (12, 32) vollständig aufnehmbar ist.

5. Hülse (2, 2') nach einem der Ansprüche 3 oder 4, **dadurch gekennzeichnet, dass** die Hülse (2, 2') an einem Ende einen normal zu ihrer Längsausdehnung ausgerichteten, vorzugsweise umlaufenden Kragen (6, 6') aufweist.

6. Hülse (2, 2') nach einem der Ansprüche 3 bis 5, **dadurch gekennzeichnet, dass** ein Endbereich des Grundkörper (4, 4') zumindest zwei parallel zu einer Mittelachse des Grundkörpers (4, 4') ausgerichtete Einschnitte (18, 18') aufweist, wobei die zwischen benachbarten Einschnitten (18, 18') angeordneten Bereiche in einem Winkel von 90° zur Mittelachse (A, A') des Grundkörpers (4, 4') nach außen gefalzt sind.

7. Hülse (2, 2') nach Anspruch 6, **dadurch gekennzeichnet, dass** die Hülse (2, 2') zweiteilig ausgebildet ist wobei zumindest ein flacher Geflecht- oder Gitterabschnitt (24, 24') den Kragen (6, 6') bildet und wobei der flache Geflecht- oder Gitterabschnitt (24, 24') eine von dem Grundkörper (4, 4') durchsetzte Ausnehmung (26, 26') aufweist und in flächigern Kontakt auf den nach außen gefalzten Bereichen des Grundkörpers (4, 4') aufliegt.

8. Hülse (2, 2') nach Anspruch 7, **dadurch gekennzeichnet, dass** der flache Geflecht- oder Gitterabschnitt (24, 24') und die nach außen gefalzten Bereiche des Grundkörpers (4, 4') miteinander mechanisch, vorzugsweise durch metallische Heftkammern (28) verbunden sind.

9. Hülse (2, 2) nach einem der Ansprüche 6 bis 8, **dadurch gekennzeichnet, dass** das von dem Kragen (6, 6') beabstandete Ende der Hülse (2, 2') offen ausgebildet ist.

10. Hülse (2, 2') noch einem der Ansprüche 6 bis 9, **dadurch gekennzeichnet, dass** das von dem Kragen (6, 6') beabstandete Ende der Hülse (2, 2') geschlossen ausgebildet ist.

## Claims

1. An electromagnetic shielding for a room, with a surfaced plaiting structure or mesh structure which surrounds the room, is electrically conductive and is applied to earth potential, **characterised in that** at least one sleeve (2, 2') is provided for receiving a fastening means (12, 32) passing through the surfaced plaiting structure or mesh structure, wherein the fastening means (12, 32) is provided for fastening the plaiting structure or mesh structure on a wall (8) of the room to be shielded, and wherein the sleeve (2, 2') forms a part of the shielding.

2. An electromagnetic shielding according to claim 1, **characterised in that** it comprises electrically conductive plaiting sections or mesh sections (40', 40", 40"', 40^{IV}) which are arranged in an overlapping manner, are conductively connected to one another and are electrically connected to the earth potential and in the overlapping region are formed in a folded manner, wherein the folds (46, 48) of adjacent plaiting sections or mesh sections (40) in cross section engage into one another in a hook-like manner and wherein a fastening rail (50) of an electrically conductive material, preferably of copper, is arranged between folds (46, 48) engaging in one another in a hook-like manner.

3. A sleeve (2, 2') which forms part of an electromagnetic shielding for a room according to claim 1, and which is formed from an electrically conductive, plaiting-like or mesh-like material, **characterised in that** the sleeve (2, 2') has an elongate base body (4, 4') which is formed by a plaiting structure or mesh structure which in cross section is wound in a spiral-like manner, preferably in a multilayered manner.

4. A sleeve (2, 2') according to claim 3, **characterised in that** the sleeve (2, 2') is designed in a manner such that a region of a fastening means (12, 32) may be received in it, said region being arranged outside a surfaced plaiting structure or mesh structure of the electromagnetic shielding and said fastening means engaging through the plaiting structure or mesh structure.

5. A sleeve (2, 2') according to one of the claims 3 or 4, **characterised in that** the sleeve (2, 2') at one end comprises a preferably peripheral collar (6, 6') which is aligned normally to the longitudinal extension of the sleeve.

6. A sleeve (2, 2') according to one of the claims 3 to 5, **characterised in that** an end region of the base body (4, 4') comprises at least two notches ( 18, 18') which are aligned parallel to a middle axis of the base body (4, 4'), wherein the regions arranged between adjacent notches (18, 18') are outwardly folded at an angle of 90° to the middle axis (A, A') of the base body (4, 4')

7. A sleeve (2, 2') according to claim 6, **characterised in that** the sleeve (2, 2') is designed of two parts, wherein at least one flat plaiting section or mesh section (24, 24') forms the collar (6, 6') and wherein the flat plaiting section or mesh section (24, 24') has a recess (26, 26'), through which the base body (4, 4') passes, and lies with a surfaced contact on the regions of the base body (4, 4') which are folded outwards.

8. A sleeve (2, 2') according to claim 7, **characterised in that** the flat plaiting section or mesh section (24, 24') and the outwardly folded regions of the base body (4, 4') are mechanically connected to one another, preferably by way of metallic staples (28).

9. A sleeve (2, 2') according to one of the claims 6 to 8, **characterised in that** the end of the sleeve (2, 2') which is distanced to the collar (6, 6') is designed in an open manner.

10. A sleeve (2, 2') according to one of the claims 6 to 8, **characterised in that** the end of the sleeve (2, 2') which is distanced to the collar (6, 6') is designed in a closed manner.

## Revendications

1. Blindage électromagnétique pour un espace, comprenant une structure de treillage ou de grillage en nappe, conductrice de l'électricité, entourant l'espace et connectée au potentiel de la terre, **caractérisé en ce qu'**il est prévu au moins une gaine (2, 2') destinée à contenir un moyen de fixation (12, 32) qui traverse la structure de treillage ou de grillage en nappe, le moyen de fixation (12, 32) étant prévu pour la fixation de la structure de treillage ou de grillage à une paroi (8) de l'espace à blinder et la gaine, (2, 2') constituant une partie du blindage.

2. Blindage électromagnétique selon la revendication 1, **caractérisé en ce qu'**il présente des segments de treillage ou de grillage (40', 40", 40"', 40^{IV}) conducteurs de l'électricité disposés à recouvrement et reliés entre eux par des liaisons conductrices, qui sont connectés électriquement au potentiel de la terre et sont d'une conformation pliée dans la région de recouvrement, les plis (46, 48) des segments de treillage ou de grillage (40) adjacents s'engrenant les uns dans les autres avec une forme de crochet en section transversale, une barre de fixation (50) faite d'une matière conductrice de l'électricité, de préférence de cuivre, étant disposée entre les plis (46, 48) qui s'engrènent les uns dans les autres avec une forme de crochet.

3. Gaine (2, 2') qui forme une partie d'un blindage électromagnétique pour un espace selon la revendication 1 et qui est constituée par une matière conductrice de l'électricité, en forme de treillage ou de grillage, **caractérisée en ce que** la gaine (2, 2') présente un corps de base allongé (4, 4') qui est formé d'un treillage ou d'un grillage enroulé en spirale en section transversale, de préférence en plusieurs couches.

4. Gaine (2, 2') selon la revendication 3, **caractérisée en ce que** la gaine (2, 2') est constituée de telle sorte qu'une région d'un moyen de fixation (12, 32) qui traverse la structure de treillage ou de grillage et qui est située à l'extérieur d'une structure de treillage ou de grillage du blindage électromagnétique peut y être entièrement contenue.

5. Gaine (2, 2') selon la revendication 3 ou 4, **caractérisée en ce que** la gaine (2, 2') présente à une extrémité, une collerette (6, 6'), de préférence périphérique, orientée normalement vers son extension longitudinale.

6. Gaine (2, 2') selon l'une des revendications 3 à 5, **caractérisée en ce qu'**une région terminale du corps de base (4, 4') présente au moins deux entailles (18, 18') orientées parallèlement à un axe médian du corps de base (4, 4'), les régions situées entre les entailles voisines (18, 18') étant repliées vers l'extérieur selon un angle de 90° par rapport à l'axe médian (A, A') du corps de base (4, 4').

7. Gaine (2, 2') selon la revendication 6, **caractérisée en ce que** la gaine (2, 2') est réalisée en deux parties, au moins un segment de treillage ou de grillage plat (24, 24') formant la collerette (6, 6') et le segment de treillage ou de grillage plat (24, 24') présentant un évidement (26, 26') traversé par le corps de base (4, 4') et étant appuyé en contact intégral sur les régions du corps de base (4,4') qui sont repliées vers l'extérieur.

8. Gaine (2, 2') selon la revendication 7, **caractérisée en ce que** le segment de treillage ou de grillage plat (24, 24') et les régions du corps de base (4,4') qui sont repliées vers l'extérieur sont assemblés mécaniquement entre eux, de préférence par des agrafes métalliques (28).

9. Gaine (2, 2') selon l'une des revendications 6 à 8, **caractérisée en ce que** l'extrémité de la gaine (2, 2') à distance de la collerette (6,6') est ouverte.

10. Gaine (2, 2') selon l'une des revendications 6 à 9, **caractérisée en ce que** l'extrémité de la gaine (2, 2') à distance de la collerette (6, 6') est fermée.
